# EUROPÄISCHE PATENTSCHRIFT

(11) **EP 3 807 668 B1**
(45) Veröffentlichungstag und Bekanntmachung des Hinweises auf die Patenterteilung: **11.02.2026**
(21) Anmeldenummer: 19745984.5
(22) Anmeldetag: 09.07.2019
(51) Int. Cl.: G01R 35/00, G01R 35/02, G01R 15/20, G01R 15/24

(54) **STROMMESSWANDLEREINRICHTUNG MIT STROMMESSWANDLER UND VERFAHREN ZUM KALIBRIEREN EINES STROMMESSWANDLERS**
CURRENT-MEASURING TRANSDUCER DEVICE HAVING A CURRENT-MEASURING TRANSDUCER AND METHOD FOR CALIBRATING A CURRENT-MEASURING TRANSDUCER
DISPOSITIF À TRANSFORMATEUR DE MESURE DE COURANT POURVU D'UN TRANSFORMATEUR DE MESURE DE COURANT ET PROCÉDÉ POUR ÉTALONNER UN TRANSFORMATEUR DE MESURE DE COURANT

(30) Priorität: 07.08.2018 DE 102018213203
(43) Veröffentlichungstag der Anmeldung: 21.04.2021
(73) Patentinhaber: HSP Hochspannungsgeräte GmbH, 53842 Troisdorf (DE)
(72) Erfinder: SCHUBERTH, Stefan, 96215 Lichtenfels (DE)
(74) Vertreter: Betten & Resch
(86) Internationale Anmeldenummer: PCT/EP2019/068329
(87) Internationale Veröffentlichungsnummer: WO 2020/030360

(56) Entgegenhaltungen:
- GB-A- 2 228 337
- US-A- 3 324 393
- US-A- 4 797 607
- US-A1- 2015 160 298

## Beschreibung

Die Erfindung betrifft eine Strommesswandlereinrichtung mit einem Strommesswandler zur Messung eines elektrischen Stromes entlang eines Leitungspfades, wobei der Strommesswandler ein magnetfeldsensitives Element zum Wandeln des aus dem Stromfluss entlang des Leitungspfades resultierenden Magnetfeldes in zumindest eine physikalische Größe sowie eine Messeinrichtung zur Messung dieser physikalischen Größe aufweist.

Die Erfindung betrifft weiterhin ein Verfahren zum Kalibrieren eines Strommesswandlers zur Messung eines elektrischen Stromes entlang eines Leitungspfades, der ein magnetfeldsensitives Element zum Wandeln des aus dem Stromfluss entlang des Leitungspfades resultierenden Magnetfeldes in eine physikalische Größe aufweist.

Eine Strommesswandlereinrichtung der eingangs genannten Art ist als magnetooptischer Strommesswandler aus der Druckschrift US 3 605 013 A bekannt. Als magnetfeldsensitives Element dient dort eine Lichtleiterspule, die das aus dem Stromfluss entlang des Leitungspfades resultierende Magnetfeld in eine Änderung des Polarisationszustands von Laserlicht wandelt, welches die Lichtleiterspule passiert. Als Messeinrichtung dient eine Analysator-Detektor-Anordnung. Eine Strommesswandlereinrichtung, die auf Grundlage eines ganz ähnlichen Messprinzips arbeitet, wird in der Druckschrift DE 25 48 278 A1 gezeigt. Aus der US 2015/0160298 A1 und der GB 2 228 337 A sind Strommesswandler bekannt, bei denen Eisenkerne als magnetfeldsensitive Elemente verwendet werden, wobei die Eisenkerne jeweils von einer bestrombaren Spule umgeben sind. Aus der US 4 797 607 A ist ein magnetooptischer Strommesswandler mit einer als Spule aufgewickelten Lichtleiter bekannt, bei dem die freien Enden des Lichtleiters durch elektrische Spulen geführt sind. Die elektrischen Spulen dienen zur Erzeugung von Testpulsen. Aus der US 3 324 393 A ist ein Strommesswandler bekannt, bei dem ein optisch aktives Element in eine Lücke eines Eisenkerns eingesetzt ist um das dortige Magnetfeld zu erfassen.

Im Gegensatz zu induktiven Stromwandlern nach dem Transformator-Prinzip (im Folgenden konventionelle Strommesswandler genannt), bei denen sich der zu ermittelnde elektrische Strom entlang des Leitungspfades durch den gemessenen Strom auf der Sekundärseite und das Windungsverhältnis zwischen Primär- und Sekundärseite ergibt, müssen nicht-konventionelle Strommesswandler, wie z.B. der zuvor erwähnte magnetooptische Strommesswandler, routinemäßig kalibriert werden.

Es ist die Aufgabe der Erfindung Maßnahmen zur einfachen und zuverlässigen Kalibrierung des Strommesswandlers anzugeben.

Die Lösung der Aufgabe erfolgt durch die Merkmale der unabhängigen Ansprüche. Vorteilhafte Ausgestaltungen sind in den Unteransprüchen angegeben.

Bei der erfindungsgemäßen Strommesswandlereinrichtung mit einem Strommesswandler zur Messung eines elektrischen Stromes entlang eines Leitungspfades, der ein magnetfeldsensitives Element zum Wandeln des aus dem Stromfluss entlang des Leitungspfades resultierenden Magnetfeldes in zumindest eine physikalische Größe sowie eine Messeinrichtung zur Messung der physikalischen Größe aufweist, ist vorgesehen, dass diese Strommesswandlereinrichtung weiterhin eine Spulenanordnung zum Simulieren des aus dem Stromfluss entlang des Leitungspfades resultierenden Magnetfeldes aufweist, die eine Mehrzahl von Spulen umfasst.

Zum Kalibrieren des Strommesswandlers der Strommesswandlereinrichtung kann mittels der in der Strommesswandlereinrichtung vorhandenen Spulenanordnung ein Magnetfeld generiert werden, das Äquivalent zu dem aus dem Stromfluss entlang des Leitungspfades resultierenden Magnetfeld ist. Die für die Kalibrierung benötigten Komponenten sind also in der Strommesswandlereinrichtung bereits vorhanden, sodass für das Kalibrieren nicht extra ein Aufbau geschaffen werden muss. Weiterhin nutzen die hier zur Verfügung gestellten Komponenten das Windungsverhältnis (Windungszahl Strompfad zu Windungszahl Spulenensemble der Spulenanordnung) gemäß Transformator-Prinzip zur Kalibrierung.

Insbesondere ist vorgesehen, dass die einrichtungsinterne Anordnung und Ausrichtung der Spulenanordnung bezüglich des magnetfeldsensitiven Elements fest vorgebbar oder fest vorgegeben ist.

Es ist vorgesehen, dass das magnetfeldsensitive Element eine Ringform aufweist. Eine solche Form wird insbesondere für Durchsteckwandler benötigt.

Zumindest eine Spule der eine Mehrzahl von Spulen umfassenden Spulenanordnung umgibt das magnetfeldsensitive Element zumindest abschnittsweise. Bei der Ringform des magnetfeldsensitiven Elements bezieht sich der Begriff Abschnitt auf die umfänglichen Abschnitte der Ringform.

Es ist vorgesehen, dass das magnetfeldsensitive Element ein optisch aktives Element ist.

Mit Vorteil ist vorgesehen, dass die zumindest eine physikalische Größe
- eine den Zustand des optisch aktiven Elements bezüglich einer optischen Eigenschaft beschreibende Größe ist.

In einer weiteren vorteilhaften Ausgestaltung ist vorgesehen, dass die Strommesswandlereinrichtung einen Stromgenerator zum Bestromen der zumindest einen Spule für ein Simulieren des aus dem Stromfluss entlang des Leitungspfades resultierenden Magnetfeldes aufweist.

Schließlich ist bezüglich der Strommesswandlereinrichtung mit Vorteil vorgesehen, dass diese eine Steuer- und/oder Regeleinrichtung zur Durchführung eines Kalibierprozesses zur Kalibrierung des Strommesswandlers aufweist. Diese ist in der Regel signaltechnisch mit der Messeinrichtung und dem Stromgenerator verbunden. Bevorzugt ist die Steuer- und/oder Regeleinrichtung eine computerbasierten Steuer- und/oder Regeleinrichtung.

Bei dem erfindungsgemäßen Verfahren zum Kalibrieren eines Strommesswandlers zur Messung eines elektrischen Stromes entlang eines Leitungspfades, der ein magnetfeldsensitives Element zum Wandeln des aus dem Stromfluss entlang des Leitungspfades resultierenden Magnetfeldes in eine physikalische Größe aufweist, ist vorgesehen, dass zum Kalibrieren des Strommesswandlers das aus dem Stromfluss entlang des Leitungspfades resultierende Magnetfeld mittels einer zumindest eine Spule umfassenden Spulenanordnung simuliert, wobei der Strommesswandler Teil einer vorstehend genannten Strommesswandlereinrichtung ist und die Spulenanordnung dieser Strommesswandlereinrichtung zur Simulation des Magnetfeldes genutzt wird.

Im Folgenden werden Ausführungsbeispiele der Erfindung schematisch in Zeichnungen gezeigt und nachfolgend näher beschrieben. Dabei zeigt die
- Fig. 1: eine Anordnung aus Leitungspfad und Strommesswandlereinrichtung gemäß einer nicht zur Erfindung gehörenden Ausführungsform, und
- Fig. 2: Teile einer Strommesswandlereinrichtung gemäß einer bevorzugten Ausführungsform der Erfindung.

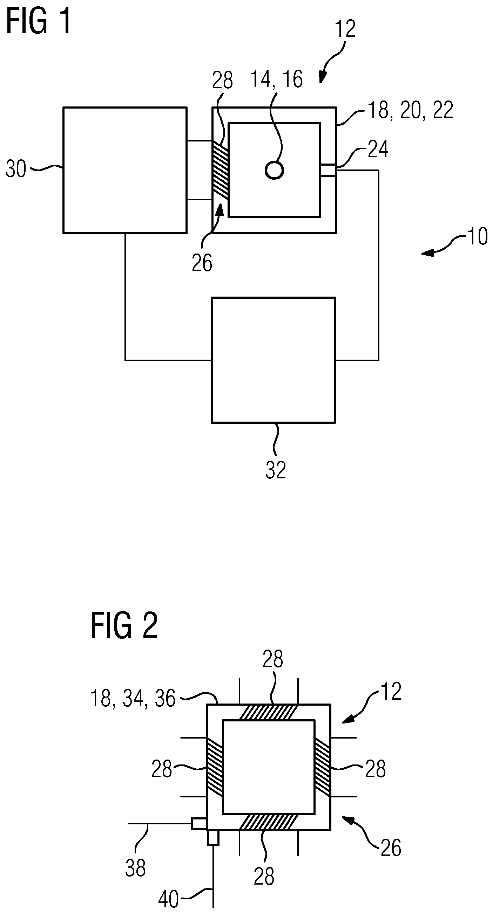

Die Figur 1 zeigt eine Strommesswandlereinrichtung 10, deren zentrale Komponente der eigentliche Strommesswandler 12 zur Messung eines elektrischen Stromes entlang eines Leitungspfades 14 ist. Dieser Leitungspfad 14 ergibt sich beispielsweise entlang eines elektrischen Leiters 16. Der Strommesswandler 12 weist ein magnetfeldsensitives Element 18 zum Wandeln des aus dem Stromfluss entlang des Leitungspfades 14 resultierenden Magnetfeldes in zumindest eine andere physikalische Größe auf. Das magnetfeldsensitive Element 18 ist ein ferromagnetisches magnetisierbares Element 20, welches eine Ring- bzw. Rahmenform aufweist, durch den der elektrische Leiter 16 geführt ist. Das magnetisierbare Element 20 ist als eine Art Ringkern 22 ausgebildet und der hier gezeigte Strommesswandler 12 ist ein sogenannter Durchsteckwandler für einen im Wesentlichen geradlinig verlaufenden Leitungspfad 14. Alternativ könnte der Leitungspfad 14 im Messbereich jedoch auch anders verlaufen, beispielsweise gewunden in Spulenform.

Der Strommesswandler 12 weist weiterhin eine am magnetfeldsensitiven Element 18 angebrachte Messeinrichtung 24 zur Messung der vom magnetfeldsensitiven Element 18 bereitgestellten physikalischen Größe auf. Im hier gezeigten Beispiel ist die Messeinrichtung 24 ein Magnetfeldsensor, der in einem Spalt im ring- oder rahmenförmigen ferromagnetischen magnetisierbaren Element 20 angeordnet und als Hall-Sensor ausgebildet ist. Ein solcher Magnetfeldsensor misst als physikalische Größe die magnetische Flussdichte B. Alternative Arten von Magnetfeldsensoren sind Förster-Sonden und XMR-Sensoren, also magnetoresistive Sensoren wie GMR-, AMR- oder CMR-Sensor.

Neben diesen Komponenten des Strommesswandlers 12 weist die Strommesswandlereinrichtung 10 auch eine Spulenanordnung 26 mit einer oder mehreren Spulen 28 auf. Im hier gezeigten Beispiel der Fig. 1 ist es nur eine einzige Spule 28. Diese umgibt einen umfänglichen Abschnitt des ring- oder rahmenförmigen ferromagnetischen magnetisierbaren Elements 20, welches bezüglich der Spule 28 einen Spulenkern, genauer gesagt den Ringkern 22 bildet. Mittels der Spulenanordnung 26 ist es möglich, das aus dem Stromfluss entlang des Leitungspfades 14 resultierende Magnetfeld zu simulieren und somit den Strommesswandler auf einfache Weise recht genau zu kalibrieren. Auch hier ergibt sich das Verhältnis zwischen dem Strom durch die Spule 28 und dem simulierten elektrischen Strom entlang des Leitungspfades 14 (mit Windungszahl N = 1) unmittelbar durch die Zahl der Windungen der Spule 28.

Die Spulenanordnung 26 weist weiterhin (hier nicht gezeigte) Anschlüsse zum Anschluss eines Stromgenerators 30 zum Bestromen der zumindest einen Spule 28 auf. Alternativ oder zusätzlich weist die Strommesswandlereinrichtung 10 diesen Stromgenerator gleich mit auf. Weiterhin weist die Strommesswandlereinrichtung 10 auch noch eine Steuer- und/oder Regeleinrichtung 32 zur Durchführung eines Kalibierprozesses zur Kalibrierung des Strommesswandlers 12 auf. Diese ist in der Regel signaltechnisch mit der Messeinrichtung 24 und dem Stromgenerator 30 verbunden. Bevorzugt ist die Steuer- und/oder Regeleinrichtung 32 eine computerbasierten Steuer- und/oder Regeleinrichtung.

Es ergibt sich folgende Funktion:
Zum Kalibrieren des Strommesswandlers 12 der Strommesswandlereinrichtung 10 wird ein aus dem Stromfluss entlang des Leitungspfades 14 resultierendes Magnetfeld mittels der in der Strommesswandlereinrichtung 10 fest installierten Spulenanordnung 26 simuliert.

Es ergeben sich folgende Vorteile:
Die für die Kalibrierung benötigten Komponenten sind in der Strommesswandlereinrichtung 10 bereits vorhanden, sodass für das Kalibrieren kein Aufbau geschaffen werden muss. Weiterhin nutzen die hier zur Verfügung gestellten Komponenten das Windungsverhältnis (Windungszahl Strompfad zu Windungszahl Spulenensemble der Spulenanordnung) gemäß Transformator-Prinzip nun zur Kalibrierung.

Mit anderen Worten: Für nicht-konventionelle Strommesswandler 12, die nicht wie induktive Stromwandlern nach dem Transformator-Prinzip arbeiten und daher kalibriert werden müssen, werden nun beim Kalibrieren die Vorteile des Transformator-Prinzips genutzt.

Die Fig. 2 zeigt eine bevorzugte Ausgestaltung einer erfindungsgemäßen Strommesswandlereinrichtung 10. Der Strommesswandler 12 dieser Strommesswandlereinrichtung 10 ist ein magnetooptischer Strommesswandler ähnlich dem magnetooptischen Strommesswandler aus der eingangs erwähnten Druckschrift US 3 605 013 A.

Das magnetfeldsensitive Element 18 ist ein optisch aktives Element 34, welches als Ringelement 36 geformt ist. Der zugrundeliegende Effekt ist beispielsweise der Faraday-Effekt und die resultierende Größe eine Drehung einer Polarisationsebene oder eine sonstige messbare Änderung einer Polarisationseigenschaft. Über einen optischen Eingang 38 wird Licht mit bekannten Polarisationseigenschaften in das Ringelement 36 eingeleitet und anschließend über einen optischen Ausgang 40 aus dem Ringelement 36 ausgeleitet und der als Polarisationsanalysator ausgebildeten Messeinrichtung 24 zugeführt.

Die Spulenanordnung 26 der in Fig. 2 gezeigten Ausführungsform weist mehrere Spulen 28 auf. Dies ist bei dieser Ausführungsform des Strommesswandlers 12 notwendig, um eine hinreichende Änderung der Polarisationseigenschaft des Lichts (z.B. Drehung der Polarisationsebene) zu generieren.

### Bezugszeichenliste

- 10: Strommesswandlereinrichtung
- 12: Strommesswandler
- 14: Leitungspfad
- 16: elektrischer Leiter
- 18: magnetfeldsensitives Element
- 20: magnetisierbares Element
- 22: Ringkern
- 24: Messeinrichtung
- 26: Spulenanordnung
- 28: Spule
- 30: Stromgenerator
- 32: Steuer- und/oder Regeleinrichtung
- 34: optisch aktives Element
- 36: Ringelement
- 38: optischer Eingang
- 40: optischer Ausgang

## Patentansprüche

1. Strommesswandlereinrichtung (10) mit einem Strommesswandler (12) zur Messung eines elektrischen Stromes entlang eines Leitungspfades (14), wobei der Strommesswandler (12) ein magnetfeldsensitives Element (18) zum Wandeln des aus dem Stromfluss entlang des Leitungspfades (14) resultierenden Magnetfeldes in zumindest eine physikalische Größe sowie eine Messeinrichtung (24) zur Messung der physikalischen Größe aufweist, mit einer Spulenanordnung (26) zum Simulieren des aus dem Stromfluss entlang des Leitungspfades (14) resultierenden Magnetfeldes, wobei das magnetfeldsensitive Element (18) ein optisch aktives Element (34) ist, **dadurch gekennzeichnet, dass**
das magnetfeldsensitive Element (18) die Form eines Ringes aufweist und dass die Spulenanordnung (26) eine Mehrzahl von Spulen (28) umfasst, von denen zumindest eine Spule (28) das magnetfeldsensitive Element (18) zumindest abschnittsweise umgibt.

2. Strommesswandlereinrichtung nach Anspruch 1,
**dadurch gekennzeichnet, dass**
die einrichtungsinterne Anordnung und Ausrichtung der Spulenanordnung (26) bezüglich des magnetfeldsensitiven Elements (18) fest vorgegeben ist.

3. Strommesswandlereinrichtung nach einem der Ansprüche 1 oder 2,
**gekennzeichnet durch**
einen Stromgenerator (30) zum Bestromen der zumindest einen Spule (28) für ein Simulieren des aus dem Stromfluss entlang des Leitungspfades (14) resultierenden Magnetfeldes.

4. Strommesswandlereinrichtung nach einem der Ansprüche 1 bis 3,
**gekennzeichnet durch**
eine Steuer- und/oder Regeleinrichtung (32) zur Durchführung eines Kalibierprozesses zur Kalibrierung des Strommesswandlers (12).

5. Verfahren zum Kalibrieren eines Strommesswandlers (12) zur Messung eines elektrischen Stromes entlang eines Leitungspfades (14), der ein magnetfeldsensitives Element (18) zum Wandeln des aus dem Stromfluss entlang des Leitungspfades (14) resultierenden Magnetfeldes in eine physikalische Größe aufweist,
**dadurch gekennzeichnet, dass**
zum Kalibrieren des Strommesswandlers (12) das aus dem Stromfluss entlang des Leitungspfades (14) resultierende Magnetfeld mittels einer zumindest eine Spule (28) umfassenden Spulenanordnung (26) simuliert wird, und der Strommesswandler (12) Teil einer Strommesswandlereinrichtung (10) nach einem der Ansprüche 1 bis 4 ist und die Spulenanordnung (26) dieser Strommesswandlereinrichtung (10) zur Simulation des Magnetfeldes genutzt wird.

## Claims

1. A current transducer device (10) having a current transducer (12) for measuring an electric current along a conduction path (14), wherein the current transducer (12) has a magnetic field-sensitive element (18) for converting the magnetic field resulting from the current flow along the conduction path (14) into at least one physical variable and a measuring device (24) for measuring the physical variable, with
a coil arrangement (26) for simulating the magnetic field resulting from the current flow along the conduction path (14), wherein the magnetic field-sensitive element (18) is an optically active element (34), **characterized in that**
the magnetic field-sensitive element (18) has the shape of a ring and that the coil arrangement (26) comprises a multitude of coils (28), of which at least one coil (28) surrounds the magnetic field-sensitive element (18) at least in sections.

2. The current transducer device as claimed in claim 1, **characterized in that**
the device-internal arrangement and orientation of the coil arrangement (26) is fixedly predefined with respect to the magnetic field-sensitive element (18).

3. The current transducer device as claimed in one of claims 1 or 2,
**characterized by**
a current generator (30) for energizing the at least one coil (28) for simulating the magnetic field resulting from the current flow along the conduction path (14).

4. The current transducer device as claimed in one of claims 1 to 3,
**characterized by**
a control and/or regulation device (32) for performing a calibration process for calibrating the current transducer (12).

5. A method for calibrating a current transducer (12) for measuring an electric current along a conduction path (14), which has a magnetic field-sensitive element (18) for converting the magnetic field resulting from the current flow along the conduction path (14) into a physical variable,
**characterized in that**,
in order to calibrate the current transducer (12), the magnetic field resulting from the current flow along the conduction path (14) is simulated by way of a coil arrangement (26) comprising at least one coil (28), and the current transducer (12) is part of a current transducer device (10) as claimed in one of claims 1 to 4 and the coil arrangement (26) of this current transducer device (10) is used to simulate the magnetic field.

## Revendications

1. Dispositif (10) à transducteur de mesure de courant, comprenant un transducteur (12) de mesure de courant pour mesurer un courant électrique le long d'un chemin de conduction (14), le transducteur (12) de mesure de courant comprenant un élément (18) sensible au champ magnétique pour convertir le champ magnétique résultant du flux de courant le long du chemin de conduction (14), en au moins une grandeur physique, ainsi qu'un dispositif de mesure (24) pour mesurer la grandeur physique, comprenant un agencement de bobines (26) pour simuler le champ magnétique résultant du flux de courant le long du chemin de conduction (14), l'élément (18) sensible au champ magnétique étant un élément optiquement actif (34), **caractérisé en ce que**
l'élément (18) sensible au champ magnétique a la forme d'un anneau et **en ce que** l'agencement de bobines (26) comprend une pluralité de bobines (28), dont au moins une bobine (28) entoure au moins partiellement l'élément (18) sensible au champ magnétique.

2. Dispositif transducteur de mesure de courant selon la revendication 1,
**caractérisé en ce que**
la disposition interne du dispositif et l'orientation de l'ensemble de bobines (26) par rapport à l'élément (18) sensible au champ magnétique sont prédéfinies de manière fixe.

3. Dispositif transducteur de mesure de courant selon la revendication 1 ou la revendication 2,
**caractérisé par**
un générateur de courant (30) pour alimenter en courant ladite au moins une bobine (28) afin de simuler le champ magnétique résultant du flux de courant le long du chemin de conduction (14).

4. Dispositif transducteur de mesure de courant selon l'une des revendications 1 à 3,
**caractérisé par**
un dispositif (32) de commande et/ou de régulation, pour mettre en œuvre un processus d'étalonnage afin d'étalonner le transducteur (12) de mesure de courant.

5. Procédé pour étalonner un transducteur (12) de mesure de courant destiné à mesurer un courant électrique le long d'un chemin de conduction (14), qui comprend un élément (18) sensible au champ magnétique pour convertir le champ magnétique résultant du flux de courant le long du chemin de conduction (14) en une grandeur physique,
**caractérisé en ce que**,
pour étalonner le transducteur (12) de mesure de courant, le champ magnétique résultant du flux de courant le long du chemin de conduction (14) est simulé au moyen d'un agencement de bobines (26) comprenant au moins une bobine (28), et le transducteur (12) de mesure de courant fait partie d'un dispositif (10) à transducteur de mesure de courant selon l'une des revendications 1 à 4, et **en ce que** l'agencement de bobines (26) de ce dispositif (10) à transducteur de mesure de courant est utilisé pour simuler le champ magnétique.
